(19)

Europäisches
Patentamt

European
Patent Office

Office européen
des brevets

(11) **EP 4 539 403 A1**

(12) **DEMANDE DE BREVET EUROPEEN**

(43) Date de publication:
**16.04.2025 Bulletin 2025/16**

(21) Numéro de dépôt: **24204688.6**

(22) Date de dépôt: **04.10.2024**

(51) Classification Internationale des Brevets (IPC):
**H04L 25/03** *(2006.01)* **H04L 1/00** *(2006.01)*
**H03M 13/00** *(2006.01)*

(52) Classification Coopérative des Brevets (CPC):
**H04L 25/03171; H04L 1/005; H04L 1/0052;**
H03M 13/251; H03M 13/3905; H03M 13/6325;
H04L 1/0055; H04L 2025/03388; H04L 2025/03401

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH MA MD TN**

(30) Priorité: **12.10.2023 FR 2310929**

(71) Demandeur: **THALES**
**92190 Meudon (FR)**

(72) Inventeurs:
• **SAHIN, Serdar**
**92622 Gennevilliers Cedex (FR)**
• **CIPRIANO, Antonio**
**92622 Gennevilliers Cedex (FR)**

(74) Mandataire: **Atout PI Laplace**
**Immeuble Up On**
**25 Boulevard Romain Rolland**
**CS 40072**
**75685 Paris Cedex 14 (FR)**

(54) **METHODE DE DEMODULATION SOUPLE MAX-LOG MAP SEMI-ANALYTIQUE**

(57) L'invention porte sur un procédé de décodage souple d'un signal numérique reçu, comprenant, pour un signal ( $x_k^e$ ) dans le plan complexe reçu et devant faire l'objet d'une interprétation en un vecteur de Q bits, un calcul de log-rapports de vraisemblance pour chaque bit du vecteur. Le signal numérique est encodé en des symboles dans le plan complexe selon une loi d'étiquetage de type Gray, ou quasi-Gray, et une table associe à chaque symbole de la constellation des autres symboles ( $\Delta_{\alpha,1} \dots \Delta_{\alpha,Q}$ ) dans le plan complexe, le procédé comprenant, après la réception dudit signal ( $x_k^e$ ), une étape d'identification (100) du symbole ( $\alpha^*$ ) de la constellation le plus proche du signal dans le plan complexe, suivie d'une étape d'extraction (101, 102) de la mémoire d'au moins certains desdits autres symboles ( $\Delta_{\alpha,1} \dots \Delta_{\alpha,Q}$ ) associés par la table de correspondance audit symbole le plus proche identifié, et enfin, par une combinaison linéaire (105) de produits des valeurs entières et imaginaires desdits symboles extraits et du signal reçu, la fourniture au contrôleur du récepteur de valeurs pour les log-rapports de vraisemblance ( $L_e(d_{k,1}) \dots L_e(d_{k,Q})$ ) des Q bits.

EP 4 539 403 A1

Fig. 5

**2**

## Description

### Domaine technique

L'invention s'inscrit dans le domaine général des télécommunications, et celui plus précisément des récepteurs pour systèmes de communication sans fil, mais aussi celui des récepteurs pour systèmes de communication filaires. Elle s'intéresse à des algorithmes de démodulation souple, ou probabiliste.

Dans le cadre de communications numériques utilisant des modulations linéaires, on cherche à transmettre de l'information à travers le canal de propagation physique par le biais des symboles issus d'alphabets finis de nombres complexes, aussi appelées constellations. Ces symboles sont utilisés pour moduler en amplitude et en phase une ou plusieurs fréquences porteuses utilisées pour générer le signal à transmettre. Il s'agit de la modulation en amplitude en quadrature (quadrature amplitude modulation - QAM en anglais).

La mise en oeuvre présentée dans le présent document fournit un procédé alternatif de mise en oeuvre de la démodulation souple max-log-MAP (MAP signifiant Maximum A Posteriori, - il s'agit d'une méthode qui maximise la probabilité a posteriori d'avoir décidé le bon symbole ou le bon bit envoyé), qui permet d'obtenir un compromis performance-complexité amélioré par rapport à l'art antérieur. L'invention est proposée notamment pour des constellations non-carrées.

### Précision du contexte technique

On considère un système de communication mono utilisateur (single user - SU en anglais), composé d'un émetteur et d'un récepteur, où un bloc de bits $\boldsymbol{b}$ de longueur $K_b$ est traité par un encodeur classique pour des modulations codées avec flux de bit entrelacés (Bit Interleved Coded Modulation - BICM en anglais). Cet encodeur BICM génère $B$ blocs de données $\boldsymbol{x}^{(b)}$, chacun composé de $K$ symboles QAM appartenant à une constellation $\mathcal{X} \subset \mathbb{C}$, où $\mathbb{C}$ est le corps des nombres complexes.

En détails, l'encodeur BICM est composé des opérations suivantes. D'abord un code correcteur d'erreur $\mathcal{C}$ associe $K_b$ bits d'information à $K_c$ bits codés, dits aussi bits du code mère, parce qu'ils sont générés par un code dit code mère ayant un taux de codage fixé. Ensuite, les $K_c$ bits codés sont fournis à un bloc d'adaptation de débit et entrelacement (rate-matching/interleaver en anglais) qui peut poinçonner ou répéter les bits codés en entrée et les entrelacer pour obtenir un mot de code $\boldsymbol{d}$, constitué de $K_d$ bits entrelacés, cette longueur étant adaptée aux ressources disponibles dans la trame de l'émetteur pour envoyer de l'information. Les bits entrelacés sont divisés en B blocs de ressource de façon telle à ce que $K_d = BKQ$, où $BK$ sont les ressources physiques disponibles, M est l'ordre de la modulation (i.e. la taille de la constellation $M = |\mathcal{X}|$) et $Q = \log_2 M$. Ainsi, si $\boldsymbol{d}_k^{(b)} \triangleq \left[ d_{k,1}^{(b)}; \ldots; d_{k,Q}^{(b)} \right]$ est le vecteur de Q-bits associé au symbole $x_k$, tel que

$$\varphi_q^{-1}\left( x_k^{(b)} \right) = d_{k,q}^{(b)}$$

, alors $\boldsymbol{d}$ peut être écrit $\boldsymbol{d} \triangleq \left[ \boldsymbol{d}_1^{(1)}; \ldots; \boldsymbol{d}_K^{(1)}; \boldsymbol{d}_1^{(2)}; \ldots; \boldsymbol{d}_k^{(b)}; \ldots; \boldsymbol{d}_K^{(B)} \right]$ .

Au récepteur, après synchronisation temporelle et fréquentielle, et éventuellement égalisation ou autres processus d'atténuation de l'interférence ou du brouillage, les symboles reçus post-traités sont désignés par $x_k^e$ .

On suppose idéalement que les $x_k^e$ sont des observations générées par un canal équivalent modélisé par un bruit blanc gaussien additif circulaire complexe (Additive White Gaussian Noise - AWGN en anglais) ajouté aux symboles transmis, ayant une variance de bruit de $v_x^e$ . Si un récepteur turbo est utilisé, alors les traitements amonts peuvent échanger des informations probabilistes (ou souples) sur les bits $d_{k,q}$ avec le décodeur, sous forme de logarithmes de rapports de vraisemblances des bits, dits log-rapports de vraisemblances (log-likelihood ratio - LLR en anglais). On note $L_a(d_{k,q})$ les LLRs a priori venant du décodeur vers le démodulateur et les traitements amont, et on note $L_e(d_{k,q})$ les LLRs extrinsèques qui sont fournis vers le décodeur. Notez qu'ici le terme « décodeur » ci-dessus inclue les opérations inverses correspondant aux opérations du codage correcteur d'erreur, et des blocs d'adaptation de débit et d'entrelacement.

L'invention présentée ci-après porte sur l'opération de de démodulation souple (appelée aussi demapper souple ou demapping souple), dont le but est de calculer des LLRs extrinsèques $L_e(d_{k,q})$ (LLR du qieme bit) sur les bits codés, en utilisant les symboles reçus et traités $x_k^e$ (estimé égalisé/reçu), la variance du bruit et de l'interférence résiduelle $v_x^e$

(variance post-égal / reçu) et les LLRs a priori $L_a(d_{k,q})$ pour $k = 1, \ldots , K$ et $q = 1, \ldots , Q$.

Ce processus est indépendant de l'indice de symbole k, c'est pourquoi cet indice est omis dans ce qui suit.

Dans l'exposé, $\mathcal{X}_q^0$ et $\mathcal{X}_q^1$ désignent les sous-ensembles de la constellation avec le qieme bit à 0 ou 1.

Du côté récepteur, pour s'approcher des performances de détection et de décodage optimales, il faut parvenir à identifier les symboles de la constellation qui ont été effectivement choisis par l'émetteur, à partir du signal reçu avec du bruit et possiblement de l'interférence. Les méthodes les plus robustes pour parvenir à cela sont les techniques dites de « démodulation souple » qui effectuent des estimations probabilistes de ces symboles, en calculant les log-rapports de vraisemblance (LLR, comme indiqué plus haut) des bits ayant été utilisés pour étiqueter le symbole transmis. Dans la suite on appelle ces LLR aussi LLR bit (bit LLR en anglais) pour les distinguer des log-rapports de vraisemblances calculés sur les éléments (symboles) de la constellation des signaux utilisée par le système. Ces dernières LLR sont appelées LLR symbole, ou symbol LLR en anglais.

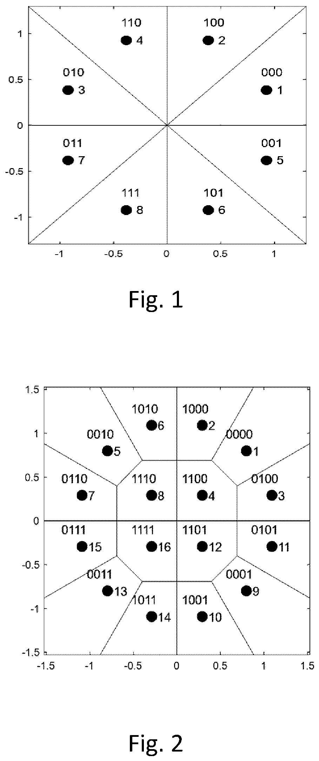

La solution exacte du problème de calcul des LLRs extrinsèques est connue, mais néanmoins, la complexité d'implémentation de cette solution n'est pas toujours envisageable pour une utilisation en pratique, selon la taille de l'alphabet (i.e. la constellation des signaux) qui est utilisé. Ainsi diverses variantes de cette solution avec des approximations simplificatrices ont été proposées. En particulier, on dispose d'excellentes solutions pour les constellations qui ont des formes géométriques carrées (en anglais « square QAM » Quadrature Amplitude Modulation : 4-QAM, 16-QAM, 64-QAM, 128-QAM etc.), mais les solutions de la littérature pour des constellations qui ne sont pas carrées ou rectangulaires (on a représenté en [Fig. 1 ]

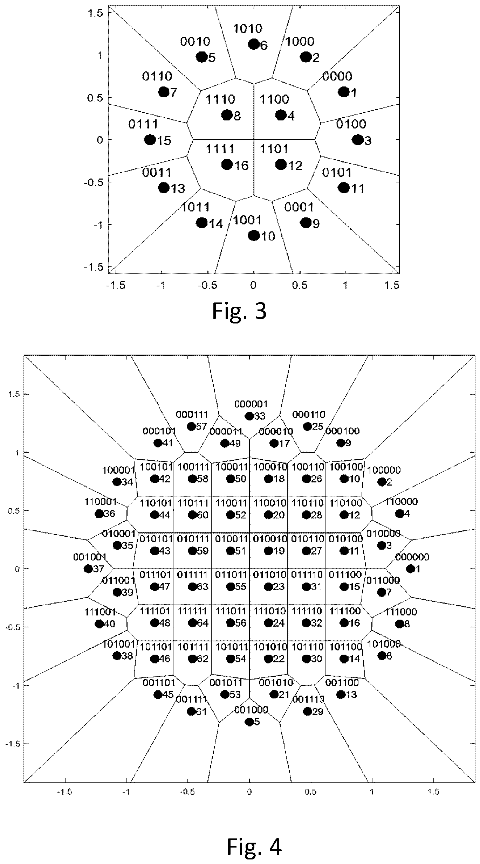

[Fig. 2] et [Fig. 3] des exemples de constellations non-carrées) peuvent toujours avoir une complexité trop élevée ou des pertes en performance de détection qui sont trop importantes pour être négligées.

**Démodulation souple dans le cas général, sans approximation**

Le demapping souple optimal est celui qui implémente l'algorithme log-MAP [1]. Dans ce cas les LLRs extrinsèques sont donnés par

$$L_e(d_q) = \log \sum_{\alpha \in \mathcal{X}_q^0} e^{-\frac{|x^e - \alpha|^2}{v_x^e} + L^a(\alpha)} - \log \sum_{\alpha' \in \mathcal{X}_q^1} e^{-\frac{|x^e - \alpha'|^2}{v_x^e} + L^a(\alpha')} - L_a(d_q)$$

avec la vraisemblance a priori sur les symboles calculée de la manière suivante :

$$L^a(\alpha) = \log[\mathcal{P}(\alpha)/\mathcal{P}(\alpha_{\text{ref}})] , \alpha_{\text{ref}}, \alpha \in \mathcal{X}$$

où $\log \mathcal{P}(\alpha) = -\sum_{q=1}^{Q} \varphi_q^{-1}(\alpha) L_a(d_q) + \text{constante}$ , $\forall \alpha \in X$. En choisissant le symbole de référence $\alpha_{\text{ref}}$

égal à celui qui a l'étiquette de $Q$ bits tous à zéros, $[0, \ldots 0] \in \mathbb{F}_2^Q$ , on obtient

$$L^a(\alpha) = -\sum_{q=1}^{Q} \varphi_q^{-1}(\alpha) L_a(d_q)$$ .

**Cas favorables des étiquetages Gray et quasi-Gray**

La fonction qui associe $Q$ bits à un symbole d'une constellation donnée (fonction dite "étiquetage") peut être choisie pour faciliter les calculs. Le choix de l'étiquetage a un impact significatif sur la façon dont les LLRs a priori de

symboles $\{L^a(\alpha)\}_{\alpha \in X}$ sur x sont liés aux LLRs a priori de bits $\{L_a(d_q)\}_{q=1}^{Q}$ .

La référence [2] contient une approximation utilisée pour le calcul des LLR bits dans le cas très utilisé en pratique dans lequel l'étiquetage entre bits et symbole (i.e. la fonction $\varphi(\boldsymbol{d}) = x$ qui associe un vecteur de bits $\boldsymbol{d}$ dit étiquette, à $x \in X$ symbole de la constellation $X$) est fait selon la méthode de Gray (indiquée par « Gray mapping » en anglais). Un loi d'étiquetage est dite « de Gray » si elle satisfait la propriété suivante : pour chaque symbole de la constellation fixé et ayant une étiquette d donnée, tous les symboles de la constellation voisins de ce dernier (i.e. ayant une distance euclidienne minimale avec lui) ont une étiquette binaire différent de d par au maximum un bit. Un étiquetage est dit quasi-Gray quand cette propriété est globalement respectée pour tous les points de la constellation sauf quelques exceptions (par ex. des symboles qui auraient plus de V> Q voisins où $Q$ est la longueur de l'étiquette, ne peuvent pas tous respecter cette règle).

Dans le cas particulier de l'étiquetage de Gray (ou Gray mapping en anglais), où par construction l'étiquette binaire entre symboles voisins ne change que sur un seul bit, les LLRs a priori de bits d'un symbole portent chacun grossièrement une quantité égale d'information mutuelle sur chaque bit [2]. Ainsi, l'approximation suivante est précise

$$L_e\big(d_q\big) \approx \log \sum_{\alpha \in \mathcal{X}_q^0} e^{-\frac{|x^e - \alpha|^2}{v_x^e}} - \log \sum_{\alpha' \in \mathcal{X}_q^1} e^{-\frac{|x^e - \alpha'|^2}{v_x^e}}.$$

En d'autres termes, pour des constellations avec étiquetage Gray ou proche de Gray (indiquées dans la suite avec « quasi-Gray », - la propriété de l'étiquetage de Gray y est satisfaite presque pour tous les symboles de la constellation), il est possible d'effectuer le calcul (exact ou approximé) des LLR bit extrinsèques directement *sur des vraisemblances de symboles.* Ensuite, si des LLR bit a posteriori sont nécessaires, les LLR bit a priori sont ajoutés séparément aux LLR bit extrinsèques ainsi calculés.

La présence d'opérations logarithmiques et exponentielles dans la formule précédente rend néanmoins cette technique lourde en termes de complexité de calcul.

**Mise en oeuvre matérielle** - **demapping souple max-log-MAP**

La formule précédente est souvent réécrite en termes de fonctions max-star, max* , avec

$$L_e\big(d_q\big) \approx \max{}^*_{\alpha \in \mathcal{X}_q^0}\left(-\frac{|x^e - \alpha|^2}{v_x^e}\right) - \max{}^*_{\alpha' \in \mathcal{X}_q^1}\left(-\frac{|x^e - \alpha'|^2}{v_x^e}\right),$$

où max*$(a, b)$ = max$(a, b) + f_J(a - b)$ et $f_J$: $x \mapsto \log(1 + e^{-|x|})$ est une fonction dite fonction de Jacobi, et s'il y a plus de deux arguments, cette fonction est associative et peut s'appliquer deux à deux séquentiellement sur des arguments multiples.

Avec cette approche, la complexité des logarithmes et des exponentielles est remplacée par la complexité du calcul des fonctions de maximum sur deux ensembles de $M/2$ éléments (donc essentiellement des comparaisons), et par le calcul de $M$ fonctions de Jacobi. La fonction de Jacobi a un comportement régulier et décroît rapidement, elle peut donc être implémentée par une table de correspondance (ou Look-Up Table - LUT, en anglais) unidimensionnelle ou être approximée par une approximation linéaire par morceaux. Dans ce cas, la LUT, étant unidimensionnelle est une liste, dont l'élément de sortie est choisi en fonction d'une entrée qui est une plage de valeurs de la droite des nombres réels.

Afin de réduire davantage la complexité, dans l'état de l'art, le calcul de la fonction de Jacobi est souvent complètement omis. Dans ce cas, on parle de demapping souple max-log-MAP et les LLR bits extrinsèques sont obtenus avec

$$L_e\big(d_q\big) \approx \frac{1}{v_x^e}\Big[\min_{\alpha' \in \mathcal{X}_q^1}(|x^e - \alpha'|^2) - \min_{\alpha \in \mathcal{X}_q^0}(|x^e - \alpha|^2)\Big].$$

Il en résulte une réduction significative de la complexité de calcul, en contrepartie d'une perte de performance.

En outre, la complexité en termes de calcul du demapping souple max-log-MAP peut encore rester prohibitive pour les constellations d'ordre élevé (par exemple 16-QAM/APSK et des nombres de symboles différents plus élevé, avec éventuellement modulation d'amplitude et de phase, APSK signifiant modulation d'amplitude et de phase, en anglais amplitude and phase-shift keying, PSK signifiant modulation par changement de phase), car cette opération nécessite toujours de calculer $M$ distances, puis d'effectuer pour chacun des $\log_2 M$ bits, un total de $M$ comparaisons, et ce processus est répété pour chaque symbole.

Le demapping souple max-log-MAP a néanmoins été largement utilisé pour la mise en oeuvre pratique de la plupart des systèmes de communication modernes, qui fonctionnent avec des décodeurs de canal à entrée souple (i.e. avec des LLR sur les bits codés).

La référence [8] fournit un aperçu de l'utilisation de cette technique pour la mise en oeuvre matérielle de nombreuses constellations issues de diverses normes.

Il existe diverses stratégies pour une implémentation matérielle efficace des opérations impliquées dans la formule max-log-MAP, telles que le calcul de la distance euclidienne, les maximums et les comparaisons, comme on peut le voir dans les références [9], [10] et [11]. Dans [9], les auteurs explorent des architectures avec multiplicateurs et multiplexeurs pour le calcul des distances et des opérations de maximum, et ils sont capables de paralléliser le calcul des LLRs sur $\log_2 M$ étages, permettant un débit égal au taux de symbole. Dans [10] et [11], les auteurs explorent l'impact des choix d'architecture matérielle liés au jeu d'instructions disponibles sur ces cibles, sur l'efficacité de la mise en oeuvre de l'algorithme max-log-MAP sur des supports matériels de type FPGA (réseau de portes programmables in situ) ou ASIC (circuit intégré propre à une application).

Bien qu'il existe un large éventail d'architectures sur max-log-MAP en général, lorsque l'on considère le cas simple d'une constellation avec étiquetage Gray, les implémentations matérielles basées sur la distance réelle et le calcul de la fonction maximum donnent un débit 3 à 6 fois plus lent par rapport aux architectures basées sur les formules analytiques de LLRs max-log-MAP. Ce résultat est montré dans le tableau 8 de la référence [8], où la référence [99] (L. Ali et al, 2015, ici la référence [12]) surpasse significativement les alternatives des références [9], [10] et [11].

De plus, les avantages en termes de complexité d'une implémentation directe de max-log-MAP sont limités pour les constellations d'ordre élevé, comme mentionné plus haut (le nombre de distances à calculer et la taille des ensemble croit linéairement avec la taille de la constellation, ou, de façon équivalente, exponentiellement avec le nombre de bits Q dans l'étiquette binaire).

Afin de réduire davantage la charge de calcul du demapping souple, les mises en oeuvre pratiques efficaces connues (référence [12]) reposent sur des expressions analytiques des

LLRs extrinsèques qui sont calculées grâce aux propriétés géométriques de chaque constellation. En particulier, il est possible de traduire directement l'approximation max-log-MAP en équations analytiques précises pour de certaines constellations avec étiquetage Gray (voir les références [3] et [5]). C'est notamment le cas de la Modulation d'Amplitude d'impulsion (Pulse Amplitude Modulation - PAM en anglais) linéaire et des constellations QAM carrées correspondantes, qui donnent des équations dont la complexité en termes de calcul est en fonction de $Q = \log_2 M$. Par ailleurs, dans le cas de la BPSK (modulation de phase binaire ou 2-PSK) et de la QPSK (Modulation en quadrature de phase) avec étiquetage de Gray, le max-log-MAP et le log-MAP exact coïncident, et les expressions analytiques de la max-log-MAP sont donc idéales.

Les expressions analytiques pour les constellations QAM (référence [3]) sont données dans la table 1, et la complexité de calcul du demapping souple d'un symbole de données est fournie.

L'estimation de la complexité est fournie en termes d'additions réelles $c$, de multiplications réelles $M_r$ et de comparaisons $C_r$. Certaines opérations d'addition ou de comparaison apparaissent parfois, au lieu des multiplications, dans la dernière colonne. En effet, il s'agit de mieux prendre en compte les multiplications avec des puissances de 2 qui peuvent être effectuées avec un décalage de bits dans une implémentation en virgule fixe.

[Tab. 1] Table 1 : Approximations analytiques du demapper souple max-log-MAP pour des constellations QAM ($M_r$, $M_r$ et $C_r$ : nombres de multiplications, additions et comparaisons, respectivement).

| Constellation | Equations | Complexité |
|---|---|---|
| BPSK (2-PAM) | $L(d_1) = 4\Re(x^e)/v_x^e$ | $M_r + A_r$ |
| QPSK (4-QAM) | $L(d_1) = 2\sqrt{2}\,\Re(x^e)/v_x^e$ <br> $L(d_2) = 2\sqrt{2}\,\Im(x^e)/v_x^e$ | $3M_r$ |
| 16-QAM | $L(d_1) = 4d(2d - |\Im(x^e)|)/v_x^e$ <br><br> $L(d_2) = 4d(2d - |\Re(x^e)|)/v_x^e$ <br><br> $L(d_3) = \begin{cases} 4d\Im(x^e)/v_x^e, & |\Im(x^e)| \le 2d \\ 8d(\Im(x^e) - d)/v_x^e, & \Im(x^e) > 2d \\ 8d(\Im(x^e) + d)/v_x^e, & \Im(x^e) < -2d \end{cases}$ <br><br> $L(d_4) = \begin{cases} 4d\Re(x^e)/v_x^e, & |\Re(x^e)| \le d \\ 8d(\Re(x^e) - d)/v_x^e, & \Re(x^e) > 2d \\ 8d(\Re(x^e) + d)/v_x^e, & \Re(x^e) < -2d \end{cases}$ <br><br> $d = 1/\sqrt{10}$ | $4M_r + 4A_r + 4C_r$ |

(suite)

| Constellation | Equations | Complexité |
|---|---|---|
| 64-QAM | $$L(d_1) = \begin{cases} 4d(|\Im(x^e)| - 2d)/v_x^e, & |\Im(x^e)| \leq 4d \\ 4d(6d - |\Im(x^e)|)/v_x^e, & |\Im(x^e)| > 4d \end{cases}$$ $$L(d_2) = \begin{cases} 4d(|\Re(x^e)| - 2d)/v_x^e, & |\Re(x^e)| \leq 4d \\ 4d(6d - |\Re(x^e)|)/v_x^e, & |\Re(x^e)| > 4d \end{cases}$$ $$L(d_3)$$ $$= \begin{cases} 8d(3d - |\Im(x^e)|)/v_x^e, & |\Im(x^e)| < 2d \\ 4d(4d - |\Im(x^e)|)/v_x^e, & 2d \leq |\Im(x^e)| \leq 6d \\ 8d(5d - |\Im(x^e)|)/v_x^e, & |\Im(x^e)| > 6d \end{cases}$$ $$L(d_4)$$ $$= \begin{cases} 8d(3d - |\Re(x^e)|)/v_x^e, & |\Re(x^e)| < 2d \\ 4d(4d - |\Re(x^e)|)/v_x^e, & 2d \leq |\Re(x^e)| \leq 6d \\ 8d(5d - |\Re(x^e)|)/v_x^e, & |\Re(x^e)| > 6d \end{cases}$$ $$L(d_5) = \text{sign}\big(\Im(x^e)\big) \times$$ $$\begin{cases} 4d|\Im(x^e)|/v_x^e, & |\Im(x^e)| < 2d \\ 8d(|\Im(x^e)| - d)/v_x^e, & 2d \leq |\Im(x^e)| \leq 4d \\ 12d(|\Im(x^e)| - 2d)/v_x^e, & 4d < |\Im(x^e)| \leq 6d \\ 16d(|\Im(x^e)| - 3d)/v_x^e, & |\Im(x^e)| > 6d \end{cases}$$ $$L(d_6) = \text{sign}\big(\Re(x^e)\big) \times$$ $$\begin{cases} 4d|\Re(x^e)|/v_x^e, & |\Re(x^e)| < 2d \\ 8d(|\Re(x^e)| - d)/v_x^e, & 2d \leq |\Re(x^e)| \leq 4d \\ 12d(|\Re(x^e)| - 2d)/v_x^e, & 4d < |\Re(x^e)| \leq 6d \\ 16d(|\Re(x^e)| - 3d)/v_x^e, & |\Re(x^e)| > 6d \end{cases}$$ $$d = 1/\sqrt{42}$$ | $5M_r + 8A_r + 6C_r$ |

En ce qui concerne les constellations non carrées, la caractérisation géométrique des LLR max-log-MAP ne fournit pas systématiquement d'expression analytique en forme close. Il existe dans la littérature quelques expressions approchées bien connues pour la 8-PSK ([4]) (celle utilisée dans l'architecture efficace de [12]) et pour la 16-APSK conforme à la norme DVB, Digital Video Broadcasting ([5]). Ces expressions et leurs coûts de calcul sont indiqués dans la table 2. Pour une telle constellation, il existe également des techniques alternatives qui tentent de minimiser l'impact de ces approximations, telles que dans les références [6] et [7], qui cherchent à exploiter les coordonnées polaires pour effectuer un max-log-MAP exact sur une constellation 8-PSK. Quoi qu'il en soit, le coût du calcul des coordonnées polaires est plus élevé que la solution révélée ci-après.

[Tab. 2] Table 2 : Approximations analytiques du demapper souple max-log-MAP pour des constellations PSK/APSK avec les méthodes publiées ($M_r$, $M_r$ et $C_r$: nombres de multiplications, additions et comparaisons, respectivement).

| Constellation | Equations | Complexité |
|---|---|---|
| 8-PSK [4] | $$L(d_1) = \frac{\sqrt{2}}{2}(\lvert \Re(x^e) \rvert - \lvert \Im(x^e) \rvert)/v_x^e$$ $$L(d_2) = \frac{\sqrt{2}}{2}\Re(x^e)/v_x^e$$ $$L(d_3) = \frac{\sqrt{2}}{2}\Im(x^e)/v_x^e$$ | $3M_r + A_r$ |
| 16-APSK (DVB) [5] | $$\alpha_{x,0} = \begin{cases} \alpha_1, & \lvert \Re(x^e) \rvert < \sqrt{3}\lvert \Im(x^e) \rvert \\ \alpha_3, & \text{otherwise} \end{cases}$$ $$\alpha_{x,1} = \begin{cases} \alpha_2, & \lvert \Im(x^e) \rvert > T_m \\ \alpha_4, & \text{sinon} \end{cases}$$ $$\alpha_{y,0} = \begin{cases} \alpha_1, & \lvert \Im(x^e) \rvert < \sqrt{3}\lvert \Re(x^e) \rvert \\ \alpha_3, & \text{sinon} \end{cases}$$ $$\alpha_{y,1} = \begin{cases} \alpha_2, & \lvert \Re(x^e) \rvert > T_m \\ \alpha_4, & \text{sinon} \end{cases}$$ $$L(d_1) = \left( \lvert x^e - \alpha_{x,1} \rvert^2 - \lvert x^e - \alpha_{x,0} \rvert^2 \right)/v_x^e$$ $$L(d_2) = \left( \lvert x^e - \alpha_{y,1} \rvert^2 - \lvert x^e - \alpha_{y,0} \rvert^2 \right)/v_x^e$$ $$L(d_3) = 1.2703 \times \Re(x^e)/v_x^e$$ $$L(d_4) = 1.2703 \times \Im(x^e)/v_x^e$$ $$T_m = 0.5 \left( R_1 \cos\left(\frac{\pi}{4}\right) + R_2 \cos\left(\frac{\pi}{12}\right) \right):$$ distance à la médiane entre les deux cercles sur les axes, | $14M_r + 8A_r + 4C_r$ |

**Utilisation de l'étiquetage binaire de la constellation**

Par ailleurs, pour s'approcher le plus possible du calcul max-log-MAP, certains travaux récents analysent plus en détails les propriétés des constellations PSK et de certaines constellations APSK (dites « product APSK » en anglais), et on constate que l'étiquetage binaire de la constellation peut être utilisé pour une mise en oeuvre efficace.

Dans [13], les auteurs proposent une nouvelle méthode pour traiter le demapping max-log-MAP des constellations PAM/QAM/PSK (et de certaines APSK symétriques) avec étiquetage de Gray au moyen de la formule :

$$L_e(d_q) \approx -\left(1 - 2\hat{d}_q^\star\right) \frac{\lvert x^e - \alpha^\star \rvert^2 - \lvert x^e - \alpha_{\bar{q}}^\star \rvert^2}{v_x^e}.$$

Dans l'expression ci-dessus :

- $\alpha^\star = \mu_{\text{hard}}^d(x^e)$ est le point (ou symbole) de la constellation le plus proche de $x^e$. Il est choisi une fois unique,

avec $\mu_{\mathrm{hard}}^{d}(\cdot)$ étant la fonction de décision dure de la constellation. On note par la suite $\hat{d}_{q}^{\star}$ le $q^{eme}$ bit (q compris entre 1 et log2(M)) de son étiquette binaire (cette grandeur prend la valeur 0 ou 1).

- $\alpha_{\bar{q}}^{\star}$ est le point (ou symbole) de la constellation le plus proche de $\alpha^*$ (à la place de $x^e$, comme l'on aurait dans le max-log-MAP idéal) et qui a la valeur $1 - \hat{d}_{q}^{\star}$ (cette grandeur prend la valeur 0 ou 1) sur le $q^{eme}$ bit.

Les auteurs dérivent une arithmétique binaire pour les constellations PAM, QAM et PSK qui permet de calculer l'étiquette binaire de $\alpha_{\bar{q}}^{\star}$ en utilisant l'étiquette binaire de $\alpha^*$. La complexité de calcul de cette méthode est donc équivalente à la complexité de détection dure simplifiée, c'est-à-dire $QC_r$, suivie du calcul de l'étiquette opposée, qui nécessite environ $Q$ opérations arithmétiques sur les bits (assimilable à des comparaisons), et enfin $Q(C_r + 7A_r + 3M_r)$ opérations pour compléter le calcul du LLR par la formule ci-dessus. Donc un total de $Q(3C_r + 7A_r + 3M_r)$ opérations est nécessaire.

Cette méthode permet d'effectuer le calcul exact de max-log-MAP en exploitant les propriétés de l'étiquetage de Gray pour trouver le symbole le plus proche $\alpha_{\bar{q}}^{\star}$ appartenant à l'ensemble $\mathcal{X}_q^0$ ou $\mathcal{X}_q^1$ opposé au symbole $\alpha^*$ déterminé par détection dure (qui est le point le plus proche du signal reçu).

Cependant, le calcul arithmétique du symbole opposé $\alpha_{\bar{q}}^{\star}$, et, plus important encore, le calcul de la formule avec les distances euclidiennes, ont toujours un poids significatif dans la complexité globale de calcul.

Par ailleurs, le document [14] s'intéresse au calcul de LLRs pour des QAM avec une généralisation aux espacements de symboles non-uniformes. Cette divulgation porte plus spécifiquement sur les QAM avec une mise en forme géométrique gaussienne. Elle est significativement différente de l'invention que l'on propose dans le présent document, qui est par ailleurs non limitée à une forme de constellation spécifique.

**Résumé de l'invention**

Le problème abordé est la démodulation souple pour estimer les log-rapport de vraisemblance (LLR) des bits correspondants aux symboles modulés. Le démapper exact est coûteux en temps de calcul à cause des exponentielles et des logarithmes. Le démapper max-log est aussi coûteux car il y a beaucoup de distances à calculer quand $M>4$. Les démappers analytiques approximent le max-log avec des propriétés géométriques de chaque constellation mais ils sont plus approximatifs pour des constellations qui ne sont pas des QAM carrées.

On cherche un compromis entre la performance et la complexité.

La solution présentée ici est d'utiliser des expressions analytiques conjointement avec des tables de correspondance LUT pour approximer le demapper max-log. Cela est applicable pour les constellations avec étiquetage Gray ou quasi-gray. C'est idéal pour des constellations non carrées comme PSK, APSK (e.g. standards DVB ou MIL-STD-110C) d'ordre 8 ou plus. L'idée est de pré-calculer pour une constellation donnée les composantes des distances qui sont liées par l'étiquettage gray ou quasi gray et les stocker dans des LUT.

On propose ainsi une stratégie dérivée à partir du max-log MAP, en utilisant les propriétés de l'étiquetage Gray, et en notant le point de constellation qui est le plus proche (identifié lors d'une décision dite dure) du signal à démoduler $x^e$, on peut écrire l'équation du log-rapport de vraisemblance de chacun des bits du vecteur à écrire pour démoduler $x^e$.

Pour résoudre les problèmes ainsi évoqués, il est proposé un procédé de décodage souple d'un signal numérique reçu par un récepteur effectuant une démodulation en quadrature, comprenant, pour un signal dans le plan complexe reçu et devant faire l'objet d'une interprétation en un vecteur de $Q$ bits - le signal en question est une observation bruitée du vecteur $Q$-bits encodé par une symbole en plan complexe - un calcul de log-rapports de vraisemblance pour chaque bit du vecteur, le procédé utilisant une table de correspondance préétablie et stockée dans une mémoire du récepteur. Ces principes sont connus, mais la table de correspondance qui est utilisée dans l'invention est très originale, et permet des performances accrues, ou une diminution de la complexité du procédé, ce qui est favorable à sa mise en oeuvre en pratique.

De manière remarquable, le signal numérique est selon l'invention encodé en des symboles dans le plan complexe selon une loi d'étiquetage de type Gray, ou quasi-Gray, et la table associe à chaque symbole de la constellation des autres symboles dans le plan complexe. Les symboles associés à un symbole par la table sont au nombre d'un par bit codé dans un symbole, à moins que ces symboles puissent se déduire les uns des autres par application d'une règle logique, auquel cas ils peuvent être moins nombreux dans la table, du fait de la présence de redites connues.

Le procédé comprend de plus après la réception dudit signal, une étape d'identification du symbole de la constellation le plus proche du signal dans le plan complexe, suivie d'une étape d'extraction de la mémoire d'au moins certains desdits autres valeurs dans le plan complexe associées par la table de correspondance audit symbole le plus proche identifié, et enfin, par un ensemble d'opérations arithmétiques fondé sur les valeurs réelles et imaginaires desdites valeurs complexes extraites et du signal reçu, la fourniture au contrôleur du récepteur de valeurs pour les log-rapports de vraisemblance des $Q$ bits pour ledit signal reçu. Les opérations peuvent être une combinaison des valeurs réelles et imaginaires extraites de la table, et des valeurs réelles et imaginaires du signal reçu, éventuellement une combinaison linéaire de produits de ces valeurs (notamment des monômes de degré 2).

Ce procédé est remarquable, car il diminue considérablement les calculs à effectuer, puisque l'essentiel des données à utiliser est disponible dans des LUTs, et donc aisément accessibles sans effort de calcul. Il est fondé sur l'analyse mathématique et logique qui est présenté ci-après, et constitue une innovation vis-à-vis de ce qui était connu, puisque on obtient des valeurs utilisables comme log-rapport de vraisemblance essentiellement en extrayant directement des valeurs préétablies dans des tables, de taille tout à fait modeste. Les calculs menés sur les valeurs extraites sont de simples multiplications et additions, à l'exclusion des logarithmes ou des exponentielles, ce qui ne consomme pas de ressources en matière de temps de calcul.

Selon des caractéristiques optionnelles et avantageuses :

- la table ou une autre table préétablie et stockée également dans une mémoire du récepteur peut associer aussi à chaque symbole de la constellation des valeurs réelles dite de distance, l'étape d'extraction comprenant alors l'extraction de valeurs réelles positives associées audit symbole le plus proche identifié, l'ensemble d'opérations arithmétiques et logiques étant alors fondé aussi sur lesdites valeurs réelles positives extraites, qui sont utilisées pour ajouter une valeur indépendante du signal reçu à la combinaison linéaire. L'élément ajouté est homogène à un produit de deux coordonnées de signal dans le plan complexe, et c'est donc typiquement un carré de distance. Il est non nul en général pour les constellations qui ne sont pas simplement polygonales.
- les éléments stockés dans la mémoire le sont sous la forme de valeurs proportionnelles à la différence entre le symbole en entrée de la table et des $Q$ symboles complémentaires par rapport aux bits de l'étiquette dudit symbole en entrée, ou de valeurs proportionnelles à la différence entre le carré du module du symbole en entrée de la table et le carré du module des $Q$ symboles complémentaires par rapport aux bits de l'étiquette dudit symbole en entrée.
- la constellation peut être une constellation PSK ou APSK, éventuellement symétrique, mais pas nécessairement.
- la constellation est par exemple une constellation 8-PSK, ou la constellation est par exemple une constellation 16-APSK.
- lors de l'étape d'extraction, il peut être tenu compte, outre du symbole de la constellation le plus proche du signal dans le plan complexe, également du résultat de tests géométriques supplémentaires fondés sur le signal reçu, pour départager des symboles de la constellation voisins de qui ont une même valeur donnée d'un certain bit.
- la table associe à chaque symbole de la constellation des autres symboles dans le plan complexe en tirant profit des symétries de la constellation pour limiter la taille de la mémoire utilisée.
- la variance d'un bruit et d'une interférence résiduelle est prise en compte dans le calcul des log-rapports de vraisemblance de chaque bit du vecteur.
- le récepteur est un récepteur turbo et les log-rapports de vraisemblance a priori du récepteur turbo sont pris en compte dans le calcul des log-rapports de vraisemblance de chaque bit du vecteur.

De manière générale, au récepteur, on commence par synchroniser en filtrant puis en effectuant une synchronisation temps/fréquence. Puis on égalise en extrayant la trame et en menant une estimation canal pour égalisation, puis on détecte en effectuant une démodulation, ce qui est l'objet de l'invention, puis enfin, on corrige les erreurs en effectuant un désentrelacement et un décodage.

Le procédé de l'invention implique un nombre limité de multiplications et d'additions en plus de la prise de décision dure (qui implique des comparaisons et 1 ou 2 éventuelles additions et multiplications). Dans le cas 8-PSK, $Q = 3$, cela donne 8 multiplications, 3 additions et 3 comparaisons et le stockage d'une LUT 3x8 comprenant deux valeurs réelles formant un nombre complexe.

## Liste des figures

L'invention va maintenant être décrite en relations avec les figures annexées, parmi lesquelles :

[Fig. 1] La figure 1 présente une constellation 8-PSK avec un étiquetage de Gray.
[Fig. 2] La figure 2 présente une constellation 16-APSK conforme à la norme DVB avec un étiquetage quasi-Gray.
[Fig. 3]
[Fig. 4] Les figures 3 et 4 montrent des constellations 16-APSK et 64-APSK conformes à la norme MIL-STD-110C (Military Standard Interoperability and Performance Standards for Data Modems) avec un étiquetage quasi-Gray.

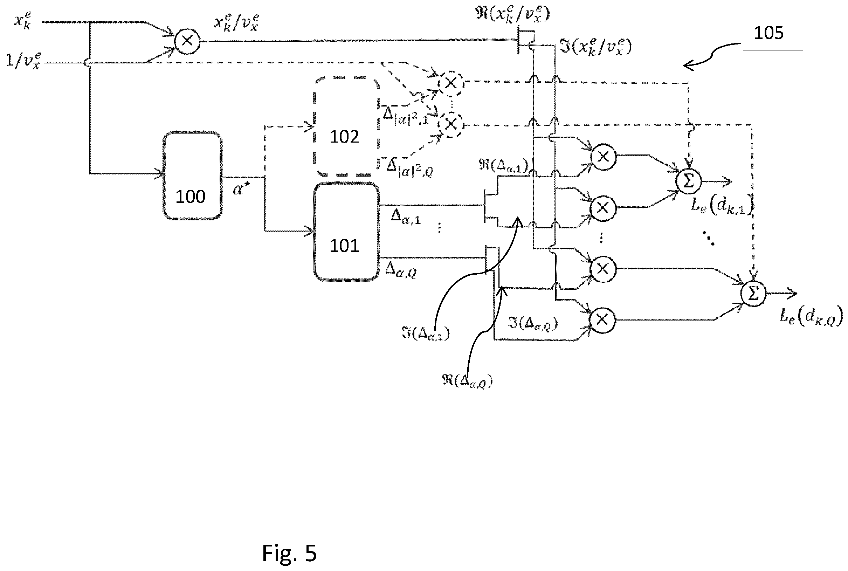

[Fig. 5] La figure 5 montre l'architecture de la solution de démapping semi-analytique max-log-MAP pour des constellations avec étiquetage (quasi-)Gray.

## Description détaillée

La solution proposée ici allège considérablement la charge de calcul des propositions de l'état de l'art.

A la place de calculer numériquement $\alpha_{\bar{q}}^{\star}$ et d'ensuite calculer des distances, il est proposé d'exploiter des LUTs dans lesquelles les symboles $\alpha_{\bar{q}}^{\star}$ et les distances correspondantes des couples $\left(\alpha^{\star}, \alpha_{\bar{q}}^{\star}\right)$, qui ont été pré-calculées, sont stockées.

Ainsi, il est substitué ainsi à un effort en termes de calculs une occupation en mémoire du récepteur, qui est cependant très limitée. La dernière formule de la section précédente peut être réécrite comme suit :

$$L_e(d_q) \approx -\left(1 - 2\hat{d}_q^{\star}\right)\frac{|x^e - \alpha^{\star}|^2 - |x^e - \alpha_{\bar{q}}^{\star}|^2}{v_x^e}$$

$$= \left(1 - 2\hat{d}_q^{\star}\right)\frac{2\Re\left(x^{e*}[\alpha^{\star} - \alpha_{\bar{q}}^{\star}]\right) - \left(|\alpha^{\star}|^2 - |\alpha_{\bar{q}}^{\star}|^2\right)}{v_x^e}.$$

Alors, en définissant $\Delta_{\alpha,q}(\alpha^{\star}) \triangleq 2\left(1 - 2\hat{d}_q^{\star}\right)\left(\alpha^{\star} - \alpha_{\bar{q}}^{\star}\right)$ et $\Delta_{|\alpha|^2,q}(\alpha^{\star}) \triangleq -\left(1 - 2\hat{d}_q^{\star}\right)\left(|\alpha^{\star}|^2 - |\alpha_{\bar{q}}^{\star}|^2\right)$, $q = 1, \ldots Q$ comme des quantités qui dépendent de $M$ valeurs possibles du point obtenu avec la détection dure $\alpha^{\star} = \mu_{\text{hard}}^d(x^e; v_x^e)$ (ou de son étiquette $\widehat{\boldsymbol{d}}_k^{\star}$ ), il est possible d'estimer le max-log-MAP avec

$$L_e(d_q) \approx \frac{\Delta_{|\alpha|^2,q}(\alpha^{\star}) + \Re(x^e)\Re\left(\Delta_{\alpha,q}(\alpha^{\star})\right) + \Im(x^e)\Im\left(\Delta_{\alpha,q}(\alpha^{\star})\right)}{v_x^e}. \tag{1}$$

Les $\Delta_{|\alpha|2,q}$ sont des nombres réels et que les $\Delta_{\alpha,q}$ sont complexes. En particulier, pour une constellation PSK, notamment 8-PSK, $\Delta_{|\alpha|2,q}(\alpha^{\star}) = 0$, pour tous les $\alpha^{\star} \in X$, ce qui réduit davantage la complexité de cette méthode (ce point n'est pas obtenu par contre pour une constellation APSK), et la formule devient

$$L_e(d_q) \approx \frac{\Re(x^e)\Re\left(\Delta_{\alpha,q}(\alpha^{\star})\right) + \Im(x^e)\Im\left(\Delta_{\alpha,q}(\alpha^{\star})\right)}{v_x^e}. \tag{2}$$

La formule précédente vaut pour toutes les constellations PSK. Un cas très intéressant est celui de la constellation 8-PSK.

[Tab. 3] Table 3: Approximations analytiques directes du demapper souple max-log-MAP selon l'invention avec la nouvelle méthode basée sur des LUTs pour des constellations PSK/APSK (**$M_r$**, **$M_r$** et **$C_r$**: nombres de multiplications, additions et comparaisons, respectivement).

| Constellation | Equations | Complexité |
|---|---|---|
| 8-PSK | Décision initiale<br><br>$$f_1 = |\Re(x^e)| < |\Im(x^e)|$$<br><br>$$f_2 = \Re(x^e) < 0$$<br>$$f_3 = \Im(x^e) < 0$$<br>Extraction de la mémoire<br>$(\Delta_{\alpha,1}, \Delta_{\alpha,2}, \Delta_{\alpha,3}) = \text{LUT\_8PSK}(f_1, f_2, f_3)$<br>opérations arithmétiques et logiques<br><br>$$L(d_1) = \left(\Re(x^e)\Re(\Delta_{\alpha,1}) + \Im(x^e)\Im(\Delta_{\alpha,1})\right)/v_x^e$$<br><br>$$L(d_2) = \left(\Re(x^e)\Re(\Delta_{\alpha,2}) + \Im(x^e)\Im(\Delta_{\alpha,2})\right)/v_x^e$$<br><br>$$L(d_3) = \left(\Re(x^e)\Re(\Delta_{\alpha,3}) + \Im(x^e)\Im(\Delta_{\alpha,3})\right)/v_x^e$$ | $8M_r + 3C_r + 3A_r +$ Stockage de deux LUTs 3x8 à sortie réelle (équivalent au stockage d'une LUT 3x8 à sortie complexe) |
| 16-APSK (DVB) | Décision initiale<br><br>$$f_1 = \left(|\Im(x^e)| > \sqrt{3}|\Re(x^e)|\right)$$<br><br>$$\vee \left((|\Re(x^e)| < T_m)\right.$$<br>$$\wedge (|\Im(x^e)| < T_b - |\Re(x^e)|))$$<br>$$f_2 = \left(|\Re(x^e)| > \sqrt{3}|\Im(x^e)|\right)$$<br>$$\vee ((|\Im(x^e)| < T_m)$$<br>$$\vee (|\Im(x^e)| < T_b - |\Re(x^e)|))$$<br>$$f_3 = \Re(x^e) < 0$$<br>$$f_4 = \Im(x^e) < 0$$<br>$$T_m = 0.5\left(R_1\cos\left(\frac{\pi}{4}\right) + R_2\cos\left(\frac{\pi}{12}\right)\right):$$<br>distance à la médiane entre les deux cercles sur les axes,<br>$$T_b = (R_1 + R_2)/\sqrt{2}:$$<br>l'ordonnée à l'origine de la médiatrice entre les rayons des deux cercles.<br>Extraction de la mémoire<br>$(\Delta_{\alpha,1}, \Delta_{\alpha,2}, \Delta_{\alpha,3}, \Delta_{\alpha,4}) = \text{LUT\_16PSK}(f_1, f_2, f_3, f_4)$<br>$(\Delta_{|\alpha|2,1}, \Delta_{|\alpha|2,2}, \Delta_{|\alpha|2,3}, \Delta_{|\alpha|2,4}) = \text{LUT\_16PSK\_P}(f_1, f_2, f_3, f_4)$ | $14M_r + 10A_r + 8C_r$ + stockage de trois LUTs 4x16 à sortie réelle (équivalent du stockage d'une LUT 4x16 à sortie complexe et d'une LUT 4x16 à sortie réelle) |
| | Opérations arithmétiques et logiques | |

(suite)

| Constellation | Equations | Complexité |
|---|---|---|
| | $$L(d_1) = \big(\Re(x^e)\Re(\Delta_{\alpha,1}) - \Im(x^e)\Im(\Delta_{\alpha,1}) + \Delta_{|\alpha|^2,1}\big)/v_x^e$$ $$L(d_2) = \big(\Re(x^e)\Re(\Delta_{\alpha,2}) - \Im(x^e)\Im(\Delta_{\alpha,2}) + \Delta_{|\alpha|^2,2}\big)/v_x^e$$ $$L(d_3) = \big(\Re(x^e)\Re(\Delta_{\alpha,3}) - \Im(x^e)\Im(\Delta_{\alpha,3}) + \Delta_{|\alpha|^2,3}\big)/v_x^e$$ $$L(d_4) = \big(\Re(x^e)\Re(\Delta_{\alpha,4}) - \Im(x^e)\Im(\Delta_{\alpha,4}) + \Delta_{|\alpha|^2,4}\big)/v_x^e$$ | |

La manière première d'implémenter avec des LUTs les formules (1) et (2) est de générer une LUT pour les différences de distances au carré (puissances 2 des distances), et surtout une LUT pour les différence de symboles, indexées toutes deux sur $\alpha^\star$, ce qui impose qu'une dimension de la table est égale au cardinal de la constellation (8 pour 8-PSK, par exemple). Ainsi, les éléments stockés dans la mémoire (dans les LUTs) le sont comme cela a été dit, sous la forme de valeurs ($\Delta_{\alpha,1}$ ... $\Delta_{\alpha,Q}$) proportionnelles à la différence entre le symbole en entrée de la table et, dans le cas présenté ici, chacun des $Q$ symboles complémentaires par rapport aux bits de l'étiquette dudit symbole en entrée, ou de valeurs ($\Delta_{|\alpha|2,1}$ ... $\Delta_{|\alpha|2,Q}$) proportionnelles à la différence entre le carré du module du symbole en entrée de la table et le carré du module de, à nouveau, chacun des $Q$ symboles complémentaires par rapport aux bits de l'étiquette dudit symbole en entrée.

Par exemple, comme mentionné dans la table 3 ci-dessus, pour la constellation 8-PSK, puisque Q = 3 bits, on génère pour chacun des 8 symboles, 3 valeurs de LUT $\Delta_{\alpha,1}$, $\Delta_{\alpha,2}$, $\Delta_{\alpha,3}$ avec une sortie complexe, indexées sur 8 valeurs possibles de $\alpha^\star$, pour un total de 3 x 2 x 8 = 48 valeurs réelles, dans une LUT 3 x 8 = 24 à sortie complexe (une LUT à 24 sorties complexes).

Pour la constellation 16-APSK, comme mentionné dans la table 3 ci-dessus, on génère pour chacun des 16 symboles, 4 valeurs de LUT $\Delta_{|\alpha|2,q}$ avec sortie réelle et 4 valeurs de LUT $\Delta_{\alpha,q}$ à sortie complexe pour un total de 4 x (1 + 2) x 16 = 192 valeurs réelles à sauvegarder en mémoire, par exemple dans deux LUT à respectivement 4 x 16 = 64 sorties réelles et 4 x 16= 64 sorties complexes.

Par rapport à cette façon première d'implémenter, deux variantes sont proposées, constituant les améliorations suivantes:

- Premièrement, on a perçu que choisir le symbole opposé $\alpha_{\bar{q}}^\star$ uniquement en fonction de $\alpha^\star$ ne correspond pas toujours à l'algorithme max-log-MAP, qui indique $\alpha_{\bar{q}}^\star$ devrait être le symbole de la constellation la plus proche de $x^e$ et qui a aussi le $q^{eme}$ bit avec signe opposé, par rapport à $\alpha^\star$. Trouver un tel symbole n'est pas un problème pour des constellations Grays comme la 8-PSK, car le couple $\big(\alpha^\star, \alpha_{\bar{q}}^\star\big)$ est toujours défini de façon unique pour tout symbole reçu $x_k^e$. Mais cela n'est plus vrai pour une constellation complexe quasi-Gray telle que la 16-APSK (définie dans la norme DVB). Dans ce cas, pour un même $\alpha^\star$, il est possible d'avoir plusieurs choix de $\alpha_{\bar{q}}^\star$ en fonction d'où se trouve le symbole $x_k^e$ à l'intérieur de la région de Voronoï de $\alpha^\star$. Il est proposé donc d'identifier le $\alpha_{\bar{q}}^\star$ le meilleur (i.e. plus proche au symbole reçu $x_k^e$) en fonction de test géométriques additionnels sur $x_k^e$. Les LUTs intègrent donc un choix plus important de couples $\big(\alpha^\star, \alpha_{\bar{q}}^\star\big)$ indexés non seulement sur $\alpha^\star$ mais aussi sur les résultats de ces tests géométriques sur $x_k^e$.

Ainsi, en notant $Q' = Q + Q_0$, où $Q$ le nombre de bits par symbole $Q = \log_2 M$, M étant l'ordre de la constellation, et $Q_0$ est le nombre de tests géométriques supplémentaires, les LUTs $\Delta_{\alpha,q}(q')$ et $\Delta_{|\alpha|2,q}(q')$ sont indexés sur au plus $q' = 0 \ldots Q'$ - 1 bits, correspondant à $M' = 2^{Q'}$ valeurs.

Par exemple, dans le cas d'une 16-APSK définie dans le DVB, après avoir pris une décision dure $\alpha^*$ sur le symbole reçu $x_k^e$ (ce qui détermine le choix de la région de Voronoï, voir figure 2), il y a 6 tests au total, ce qui conduit à 64 configurations possibles de $\left(\alpha^*, \alpha_{\tilde{q}}^\star\right)$ à la place des 16 possibilités déterminées par décision dure $\alpha^*$ seule. En utilisant tous ces tests la solution proposée est décrite dans la table 4.

[Tab. 4] Table 4: Approximations analytiques du demapper souple max-log-MAP pour des constellations 16-APSK avec la nouvelle méthode basée sur des LUTs et avec précision accrue grâce à des tests géométriques (**$M_r$**, **$M_r$** et **$C_r$**: nombres de multiplications, additions et comparaisons, respectivement).

| Constellation | Equations | Complexité |
|---|---|---|
| | Décision initiale | $14 M_r + 10 A_r + 8 C_r$ + stockage de trois LUTs 4x64 à sortie réelle (équivalent du stockage d'une LUT 4x64 à sortie complexe et d'une LUT 4x64 à sortie réelle) |
| 16-APSK (DVB) | $$f_1 = |\Re(x^e)| < \sqrt{3}|\Im(x^e)|$$ $$f_2 = |\Im(x^e)| < \sqrt{3}|\Re(x^e)|$$ $$f_3 = |\Re(x^e)| > T_m$$ | |
| | $f_4 = |\Im(x^e)| > T_m$ $f_5 = (\sim f_2) \vee ((\sim f_3) \wedge (|\Im(x^e)| < T_b - |\Re(x^e)|))$ $f_6 = (\sim f_1) \vee ((\sim f_4) \wedge (|\Im(x^e)| < T_b - |\Re(x^e)|))$ $$T_m = 0.5\left(R_1 \cos\left(\frac{\pi}{4}\right) + R_2 \cos\left(\frac{\pi}{12}\right)\right):$$ la distance à la médiane entre les deux cercles sur les axes, $$T_b = (R_1 + R_2)/\sqrt{2}$$ : l'ordonnée à l'origine de la médiatrice entre les rayons des deux cercles. Extraction de la mémoire $(\Delta_{\alpha,1}, \Delta_{\alpha,2}, \Delta_{\alpha,3}, \Delta_{\alpha,4}) = \text{LUT\_16PSK}(f_1, f_2, f_3, f_4, f_5, f_6)$ $(\Delta_{|\alpha|2,1}, \Delta_{|\alpha|2,2}, \Delta_{|\alpha|2,3}, \Delta_{|\alpha|2,4}) = \text{LUT\_16APSK\_P}(f_1, f_2, f_3, f_4, f_5, f_6)$ Opérations arithmétiques et logiques $$L(d_1) = \left(\Re(x^e)\Re(\Delta_{\alpha,1}) - \Im(x^e)\Im(\Delta_{\alpha,1}) + \Delta_{|\alpha|^2,1}\right)/v_x^e$$ $$L(d_2) = \left(\Re(x^e)\Re(\Delta_{\alpha,2}) - \Im(x^e)\Im(\Delta_{\alpha,2}) + \Delta_{|\alpha|^2,2}\right)/v_x^e$$ $$L(d_3) = \left(\Re(x^e)\Re(\Delta_{\alpha,3}) - \Im(x^e)\Im(\Delta_{\alpha,3}) + \Delta_{|\alpha|^2,3}\right)/v_x^e$$ $$L(d_4) = \left(\Re(x^e)\Re(\Delta_{\alpha,4}) - \Im(x^e)\Im(\Delta_{\alpha,4}) + \Delta_{|\alpha|^2,4}\right)/v_x^e$$ | |

Ainsi, la dimension $M'$ des LUTs peut être multipliée par le nombre de LLRs bits par symbole $Q$ et donner l'espace total occupé $QM'$ (on rappelle que $M$ est l'ordre, la taille ou le cardinal - ces mots étant ici des synonymes, de la constellation, et que $Q$ est le logarithme en base de 2 de $M$ - c'est aussi le nombre de bits codant un symbole, $M' > M$ prend en compte les $Q'$ comparaisons géométriques binaires qui complémentent la décision dur).

Pour 8-PSK $M = 8$, $Q = 3$ *et* $QM = 24$.

Pour 16-APSK, pour lequel cette variante s'applique utilement, $M' = 64$, $Q = 4$, et $QM' = 256$.

- Deuxièmement, l'occupation en mémoire peut être réduite en exploitant les symétries existantes dans la constellation et en indexant la LUT sur la sortie des tests géométriques pertinents sur le symbole reçu $x_k^e$.

- En prenant en considération la solution 16-APSK discutée précédemment (table 4), en éliminant la dépendance des tests non pertinents pour chaque sortie de LUT, et en exploitant la symétrie dans les quadrants du plan complexe, la taille des LUT est minimisée pour chaque LLR, ce qui donne un total, en table 5, de deux LUTs avec une entrée indexée sur 2 bits (une dimension égale à 4) et deux LUTs avec une entrée indexée sur 3 bits (une dimension égale à 8), au lieu de 4 LUTs avec une entrée indexée sur 6 bits (une dimension égale à 64 en table 4). Ce demapping 16-APSK ne dépend pas seulement des régions de Voronoï de la constellation (voir les contours des régions de Voronoï dans la Figure 3) mais aussi des valeurs de $\Re$ ($x^e$) et $\Im$ ($x^e$) par rapport à $T_m$.

- De façon semblable, pour la 8-PSK, la taille des LUTs peut être réduite à une simple comparaison, même si le nombre d'opérations nécessaires à l'algorithme reste le même. Cela est montré dans la table 5 où les entrées non pertinentes sont supprimées et les signes des LLRs sont ajustés en fonction de la symétrie de l'entrée.

[Tab. 5] Table 5 : Approximations analytiques du demapper souple max-log-MAP pour des constellations PSK/APSK avec la nouvelle méthode basée sur des LUTs.

| **Constellation** | **Equations** | **Complexité** |
|---|---|---|
| 8-PSK | Décision initiale <br><br> $f_1 = \|\Re\ (x^e)\| < \|\Im\ (x^e)\|$ <br><br> Extraction de la mémoire <br><br> $(\Delta_{\alpha,1}, \Delta_{\alpha,2}, \Delta_{\alpha,3}) = \text{LUT\_8PSK}(f_1)$ <br><br> Opérations arithmétiques et logiques <br><br> $$L(d_1) = \left(\|\Re(x^e)\|\Re(\Delta_{\alpha,1}) + \|\Im(x^e)\|\Im(\Delta_{\alpha,1})\right)/v_x^e$$ <br><br> $$L(d_2) = \text{sign}(\Re(x^e))\left(\|\Re(x^e)\|\Re(\Delta_{\alpha,2})\right.$$ $$\left. + \|\Im(x^e)\|\Im(\Delta_{\alpha,2})\right)/v_x^e$$ <br><br> $$L(d_3) = \text{sign}(\Im(x^e))\left(\|\Re(x^e)\|\Re(\Delta_{\alpha,3})\right.$$ $$\left. + \|\Im(x^e)\|\Im(\Delta_{\alpha,3})\right)/v_x^e$$ | $8M_r + 3C_r + 3A_r +$ stockage de deux LUTs 3x2 à sortie réelle (équivalent du stockage d'une LUT 3x2 à sortie complexe) |

(suite)

| Constellation | Equations | Complexité |
|---|---|---|
| 16-APSK (DVB) | Décision initiale $$f_1 = |\Re(x^e)| < \sqrt{3}|\Im(x^e)|$$ $$f_2 = |\Im(x^e)| < \sqrt{3}|\Re(x^e)|$$ $f_3 = |\Re(x^e)| > T_m$ $f_4 = |\Im(x^e)| > T_m$ $f_5 = (\sim f_2) \vee ((\sim f_3) \wedge (|\Im(x^e)| < T_b - |\Re(x^e)|))$ $f_6 = (\sim f_1) \vee ((\sim f_4) \wedge (|\Im(x^e)| < T_b - |\Re(x^e)|))$ $i_{\text{LUT1}} = 1 + f_4 + 2f_1$ $i_{\text{LUT2}} = 1 + f_3 + 2f_2$ $i_{\text{LUT3}} = 1 + f_5 + 2f_6 + 4f_4$ $i_{\text{LUT4}} = 1 + f_5 + 2f_6 + 4f_3$ $$T_m = 0.5\left(R_1 \cos\left(\frac{\pi}{4}\right) + R_2 \cos\left(\frac{\pi}{12}\right)\right):$$ la distance à la médiane entre les deux cercles sur les axes, $T_b = (R_1 + R_2)/\sqrt{2}$ : l'ordonnée à l'origine de la médiatrice entre les rayons des deux cercles Extraction de la mémoire $(\Delta_{\alpha,1}, \Delta_{|\alpha|2,1}) = \text{LUT\_16APSK\_L1}(i_{\text{LUT1}})$ $(\Delta_{\alpha,2}, \Delta_{|\alpha|2,2}) = \text{LUT\_16APSK\_L2}(i_{\text{LUT2}})$ $(\Delta_{\alpha,3}, \Delta_{|\alpha|2,3}) = \text{LUT\_16APSK\_L3}(i_{\text{LUT3}})$ $(\Delta_{\alpha,4}, \Delta_{|\alpha|2,4}) = \text{LUT\_16APSK\_L4}(i_{\text{LUT4}})$ Opérations arithmétiques et logiques $$L(d_1) = \left(|\Re(x^e)|\Re(\Delta_{\alpha,1}) - |\Im(x^e)|\Im(\Delta_{\alpha,1}) + \Delta_{|\alpha|^2,1}\right)/v_x^e$$ $$L(d_2) = \left(|\Re(x^e)|\Re(\Delta_{\alpha,2}) - |\Im(x^e)|\Im(\Delta_{\alpha,2}) + \Delta_{|\alpha|^2,2}\right)/v_x^e$$ $$L(d_3) = \text{sign}\left(\Re(x^e)\right)\left(|\Re(x^e)|\Re(\Delta_{\alpha,3}) - |\Im(x^e)|\Im(\Delta_{\alpha,3}) + \Delta_{|\alpha|^2,3}\right)/v_x^e$$ $$L(d_4) = \text{sign}\left(\Im(x^e)\right)\left(|\Re(x^e)|\Re(\Delta_{\alpha,4}) - |\Im(x^e)|\Im(\Delta_{\alpha,4}) + \Delta_{|\alpha|^2,4}\right)/v_x^e$$ | $12M_r + 9A_r + 8C_r$ + Stockage de trois LUTs à sortie réelle 2x4 et de trois LUTs à sortie réelle 2x8 à nouveau les groupes de trois LUTs équivalent à une LUT à sortie complexe et une LUT à sortie réelle |

En conclusion, cette approche semi-analytique permet de développer des solutions spécifiques pour les constellations 8-PSK, 16-APSK de type DVB et d'autres constellations QAM non carrées, qui peuvent atteindre une performance proche (16-APSK) voire égale (8-PSK) au max-log-MAP. L'idée générale est de combiner l'utilisation de décisions dures à faible complexité (ou ses extensions aux décisions sur la paire $\left(\alpha^{\star}, \alpha^{\star}_{\bar{q}}\right)$) avec des LUT sur les différences des symboles et de leur puissances, comme le montre la figure 5.

Des propositions spécifiques pour la 8-PSK et 16-APSK sont données dans table 5. L'invention pour la 8-PSK donne donc une façon alternative et avantageuse de calculer le max-log-MAP exact. L'invention pour la 16-APSK compatible DVB ne permet pas de calculer le max-log-MAP exact, puisque cette constellation n'a pas un étiquetage de Gray idéal. A noter que, pour la 16-APSK, l'invention fournit des LUTs optimisés en taille, notamment deux LUTs de taille 8 pour les premières deux LLRs et de taille 16 pour les dernières deux LLRs. La complexité totale et l'occupation en mémoire des LUTs de l'invention révélée ici est plus importante que dans les solutions de l'état de l'art [4][5] mais la perte de performances est plus réduite que pour ces alternatives peu complexes de l'état de l'art.

La mise en oeuvre de l'invention dépendra de la cible logicielle ou matérielle dans laquelle cette opération de soft demapping a pour vocation d'être implémentée. Cela dépendra aussi des types de quantités manipulées : selon si les valeurs numériques sont implémentées de type virgule fixe ou flottante, la mise en oeuvre spécifique de ces opérations ne sera pas identique.

Sur un environnement purement numérique comme un FPGA ou ASIC, avec une implémentation virgule fixe, la manipulation des bits de signe étant très facile, il sera préférable de réduire les quantités $\Delta_{\alpha,q}$ redondantes stockées dans des LUTs, et d'utiliser plus de comparaisons bit-à-bit pour ajuster le signe de ces quantités comme sur la table 5

A l'inverse, sur un DSP ou processeur, où une comparaison équivaut à une addition, les accès aux LUTs peuvent devenir beaucoup plus intéressants que d'effectuer des opérations telles qu'additions ou multiplications, lorsque la mémoire où ces LUTs se trouvent est facilement accessible. Ainsi une implémentation avec plusieurs LUTs qui contiennent des données redondantes comme $\Delta_{\alpha,q}$ et $-\Delta_{\alpha,q}$ serait préférable pour des raisons de latence.

Il est donc important de considérer la cible, lors de la construction des LUTs et des règles de comparaisons pour une constellation donnée.

L'invention, sans que cela ne soit limitatif, s'appuie sur des décisions dures et d'autres comparaisons géométriques relativement simples pour indexer des tables de correspondance (LUTs) qui eux contiennent les quantités intermédiaires exactes nécessaire pour calculer les LLR bit selon à l'algorithme max-log-MAP. Permettant ainsi une mise en oeuvre de max-log-MAP qui évite de calculer autant de distances que de points dans la constellation, et par la suite de comparer ces distances. La méthode est définie donc semi-analytique parce qu'elle mélange des formules analytiques avec des LUT, différemment de l'état de l'art.

La solution révélée diminue la complexité de certaines solutions de l'état de l'art pour le calcul des LLR bit extrinsèques avec la méthode max-log-MAP exacte, tout en gardant les mêmes performances pour des constellations non-carrées (comme 8-PSK et $M$-PSK $M > 8$, et les constellations $M$-APSK).

Certaines solutions de l'état ont une très faible complexité mais elles approximent fortement le calcul de la méthode max-log-MAP avec des formules analytiques, ce qui conduit à une perte de performance. Par rapport à ces méthodes, la solution révélée ici est légèrement plus complexe et nécessite de garder dans la mémoire du récepteur des tables de valeurs pré-calculées (LUT), mais elle permet de maintenir les performances de la méthode max-log-MAP.

L'invention est intéressante pour les communications militaires. Elle pourrait être intéressante par exemple pour les communications HF. Elle s'applique en particulier aux constellations 16-APSK et 64-APSK conformes à la norme MIL-STD-110C (Military Standard Interoperability and Performance Standards for Data Modems) avec un étiquetage quasi-Gray.

La détection est possible en faisant des tests de performance dans un environnement maîtrisé, notamment en accédant à des métriques de couche PHY.

On gagne en performance pour une quantité de calcul donnée, donc on gagne au niveau de l'énergie consommée. Cela est très utile notamment pour les communications militaires.

L'achitecture de la solution, représentée en figure 5, est donc constituée d'une décision dure 100, typiquement sur la base de $Q'$ comparaisons (plus quelques additions ou multiplications pour les constellations APSK), suivie de l'utilisation d'une LUT 101 des écarts de symbole : $M'$ valeurs d'entrée possibles pour $Q$ sorties complexes, avec éventuellement l'utilisation en parallèle d'une LUT 102 des écarts de carrés de distance : $M'$ valeurs d'entrée possibles pour Q sorties réelles. Les éléments en pointillés ne sont pas requis pour les constellations PSK, car les carrés des distances sont tous égaux. Des opérations arithmétiques 105 sont menées ensuite sur la base des valeurs extraites des LUTs, et de la valeur du signal à décoder $x^e_k$.

En matière de performance, on a pour 8-PSK, des gains de l'ordre de 0.6-0.9 dB dans un canal simple à bruit additif gaussien (additive white gaussian noise - AWGN en anglais) pour un taux d'erreur paquet cible inférieur à $10^{-2}$ et un taux de codage de ½. Les gains sont d'autant plus importants que le rendement de code est faible. Les gains sont plus importants si le canal est sélectif en fréquence.

Au final, l'invention proposé exploite la combinatoire finie des étiquetages Gray pour créer des LUTs de petite taille ce qui permet un calcul de LLR plus précis avec une complexité modérée. On atteint la qualité des LLR max-log MAP avec une complexité significativement moindre, tout en améliorant la qualité des LLRs vis-à-vis des méthodes analytiques, avec une complexité relativement maîtrisée.

Grâce à l'invention, on atteint la qualité des LLRs max-log MAP avec une complexité moindre, on améliore la qualité des LLRs vis-à-vis des méthodes analytiques, et on maîtrise la complexité.

Liste des références citées

[1] S. ten Brink, J. Speidel and Ran-Hong Yan, "Iterative demapping and decoding for multilevel modulation," Proceedings of the IEEE GLOBECOM 1998, pp. 579-584 vol.1, Sydney, NSW, Australia, 8-12 Nov. 1998.

[2] S. ten Brink, "Designing itérative decoding schemes with the extrinsic information transfer chart," AEU Int. J. Electron/Commun., pp. 389-398 vol.54, no.6, 2000.

[3] F. Tosato and P. Bisaglia, "Simplified Soft-Output Demapper for Binary Interleaved COFDM with Application to HIPERLAN/2", Proceedings of IEEE ICC 2002, New York City, NY, USA, 28 Apr. - 02 May 2002.

[4] Michael K. Cheng, Dariush Divsalar, and Stephanie Duy. "Structured low-density parity-check codes with bandwidth efficient modulation." Wireless Sensing and Processing IV. Vol. 7349. SPIE, 2009.

[5] Chatzikontantinou Christos, and Spafaridis Xenofon. "A novel soft-demapping algorithm for 16-APSK, for systems employing uncoded modulation.", Proceedings of the Pan-Hellenic Electrical and Computer Engineering Student Conférence, Vol. 7, Thessaloniki, Greece, Apr. 2014.

[6] Li, Jianping and Yameng Shi. "Simplified Soft-output Demapper Based on a Linear Transformation Technique for M-ary PSK", Sensors & Transducers, vol. 181, n° 10, Oct. 2014.

[7] A. Barre, E. Boutillon, N. Bias and D. Diaz, "A polar-based demapper of 8PSK démodulation for DVB-S2 systems," SiPS 2013 Proceedings, Taipei, Taiwan, 16-18 Oct. 2013.

[8] Mostafa Rizk, Amer Baghdadi, Michel Jézéquel, "A Literature Survey on Algorithms and Hardware Architectures of Max-Log-MAP Demapping", Journal of Circuits, Systems and Computers, vol.31, no.03, 2022.

[9] J. W. Park, M. H. Sunwoo, P. S. Kim and D.-I. Chang, "Low complexity soft-decision demapper for high order modulation of DVB-S2 System", in Proc. of the IEEE International SoC Design Conference (ISOCC), 02 Nov. 2008.

[10] A. Baghdadi and M. Jezequel, "ASIP-based universal demapper for multiwireless standards", IEEE Embedded Systems Letters, no. 1, pp. 9-13, May 2009.

[11] M. Rizk, A. Baghdadi, M. Jezequel, Y. Mohanna and Y. Atat, "NISC-based soft-input soft-output demapper", IEEE Transactions on Circuits and Systems, vol. 62, Nov. 2015.

I. Ali, U. Wasenmüller and N. Wehn, "A high throughput architecture for a low complexity soft-output demapping algorithm", Advances in Radio Science, vol.13, 2015.

Q. Wang, Q. Xie, Z. Wang, S. Chen and L. Hanzo, "A Universal Low-Complexity Symbol-to-Bit Soft Demapper", IEEE Transactions on Vehicular Technology, vol. 63, no. 1, Jan. 2014.

US10003436B2, "Low-complexity LLR computation for nonuniform QAM constellations".

**Revendications**

**1.** Procédé de décodage souple d'un signal numérique reçu par un récepteur effectuant une démodulation en quadrature, comprenant, pour un signal ( $x_k^e$ ) dans le plan complexe reçu et devant faire l'objet d'une interprétation en un vecteur de Q bits, un calcul de log-rapports de vraisemblance pour chaque bit du vecteur, le procédé utilisant une table de correspondance préétablie et stockée dans une mémoire du récepteur, et le procédé étant **caractérisé en ce que** le signal numérique est encodé en des symboles dans le plan complexe selon une loi d'étiquetage de type Gray, ou quasi-Gray, et la table associe à chaque symbole de la constellation des autres valeurs ($\Delta_{\alpha,1} ... \Delta_{\alpha,Q}$) dans le plan complexe, le procédé comprenant, après la réception dudit signal ( $x_k^e$ ), une étape d'identification (100) du symbole ($\alpha^*$) de la constellation le plus proche du signal dans le plan complexe, suivie d'une étape d'extraction (101, 102) de la mémoire d'au moins certaines desdites autres valeurs ($\Delta_{\alpha,1} ... \Delta_{\alpha,Q}$) dans le plan complexe associées par la table de correspondance audit symbole le plus proche identifié, et enfin, par une combinaison (105) des valeurs réelles et imaginaires desdites valeurs dans le plan complexe extraites et du signal reçu, la fourniture au contrôleur du récepteur de valeurs pour les log-rapports de vraisemblance ($L_e (d_{k,1}) ... L_e (d_{k,Q})$) des Q bits pour ledit signal reçu.

**2.** Procédé de décodage souple selon la revendication 1, **caractérisé en ce que** la table ou une autre table préétablie et stockée également dans une mémoire du récepteur associe aussi à chaque symbole de la constellation des valeurs réelles positives ($\Delta_{|\alpha|2,1} \ldots \Delta_{|\alpha|2,Q}$), l'étape d'extraction (101, 102) comprenant l'extraction de la mémoire d'au moins certaines desdites valeurs réelles positives associées par la table de correspondance audit symbole le plus proche identifié, la combinaison étant une combinaison linéaire (105) incluant un terme indépendant du signal reçu et fondé sur lesdites valeurs réelles positives extraites.

3. Procédé de décodage souple selon la revendication 1 ou la revendication 2, **caractérisé en ce que** les éléments stockés dans la mémoire le sont sous la forme de valeurs ($\Delta_{\alpha,1} \ldots \Delta_{\alpha,Q}$) proportionnelles à la différence entre le symbole en entrée de la table et des $Q$ symboles complémentaires par rapport aux bits de l'étiquette dudit symbole en entrée, ou de valeurs ($\Delta_{|\alpha|2,1} \ldots \Delta_{|\alpha|2,Q}$) proportionnelles à la différence entre le carré du module du symbole en entrée de la table et le carré du module des $Q$ symboles complémentaires par rapport aux bits de l'étiquette dudit symbole en entrée.

4. Procédé de décodage souple selon l'une des revendications 1 à 3, **caractérisé en ce que** la constellation est une constellation PSK ou APSK.

5. Procédé de décodage souple selon la revendication 4, **caractérisé en ce que** la constellation est une constellation 8-PSK.

6. Procédé de décodage souple selon la revendication 4, **caractérisé en ce que** la constellation est une constellation 16-APSK.

7. Procédé de décodage souple selon l'une des revendications 1 à 6, **caractérisé en ce que** lors de l'étape d'extraction (101, 102), il est tenu compte, outre du symbole ($\alpha^*$) de la constellation le plus proche du signal dans le plan complexe, également du résultat de tests géométriques supplémentaires fondés sur le signal reçu ($x_k^e$), pour départager des symboles de la constellation voisins de ($\alpha^*$) qui ont une même valeur donnée d'un certain bit.

8. Procédé de décodage souple selon l'une des revendications 1 à 7, **caractérisé en ce que** la table associe à chaque symbole de la constellation des autres symboles dans le plan complexe en tirant profit des symétries de la constellation pour limiter la taille de la mémoire utilisée.

9. Procédé de décodage souple selon l'une des revendications 1 à 8, **caractérisé en ce que** la variance ($v_x^e$) d'un bruit et d'une interférence résiduelle est prise en compte dans le calcul des log-rapports de vraisemblance de chaque bit du vecteur.

10. Procédé de décodage souple selon l'une des revendications 1 à 9, **caractérisé en ce que** le récepteur est un récepteur turbo et les log-rapports de vraisemblance a priori du récepteur turbo sont pris en compte dans le calcul des log-rapports de vraisemblance de chaque bit du vecteur.

Fig. 1

Fig. 2

Fig. 3

Fig. 4

Fig. 5

| Europäisches Patentamt European Patent Office Office européen des brevets | **RAPPORT DE RECHERCHE EUROPEENNE** | Numéro de la demande EP 24 20 4688 |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2009/231028 A1 (WANG SHUANGQUAN [US] ET AL) 17 septembre 2009 (2009-09-17) * alinéa [0031] - alinéa [0058] * * figures 4,5 * ----- | 1-10 | INV. H04L25/03 H04L1/00 H03M13/00 |
| A | CN 114 465 695 B (BEIJING FINTO SCIENCE AND TECH CO LTD) 19 juillet 2022 (2022-07-19) * alinéa [0002] * ----- | 1-10 | |

**DOMAINES TECHNIQUES RECHERCHES (IPC)**

H04L
H03M

Le présent rapport a été établi pour toutes les revendications

| Lieu de la recherche | Date d'achèvement de la recherche | Examinateur |
|---|---|---|
| Munich | 6 février 2025 | Schiffer, Andrea |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C02)

**EP 4 539 403 A1**

## ANNEXE AU RAPPORT DE RECHERCHE EUROPEENNE
## RELATIF A LA DEMANDE DE BREVET EUROPEEN NO.

EP 24 20 4688

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-02-2025

| Document brevet cité au rapport de recherche | Date de publication | Membre(s) de la famille de brevet(s) | Date de publication |
|---|---|---|---|
| US 2009231028 A1 | 17-09-2009 | US 2009231028 A1<br>WO 2009114024 A1 | 17-09-2009<br>17-09-2009 |
| CN 114465695 B | 19-07-2022 | AUCUN | |

EPO FORM P0460

## RÉFÉRENCES CITÉES DANS LA DESCRIPTION

**Documents brevets cités dans la description**

- US 10003436 B2

**Littérature non-brevet citée dans la description**

- **S. TEN BRINK** ; **J. SPEIDEL** ; **RAN-HONG YAN**. Iterative demapping and decoding for multilevel modulation. *Proceedings of the IEEE*, 08 November 1998, vol. 1, 579-584
- **S. TEN BRINK**. Designing itérative decoding schemes with the extrinsic information transfer chart. *AEU Int. J. Electron/Commun.*, 2000, vol. 54 (6), 389-398
- **F. TOSATO** ; **P. BISAGLIA**. Simplified Soft-Output Demapper for Binary Interleaved COFDM with Application to HIPERLAN/2. *Proceedings of IEEE ICC*, 2002
- **MICHAEL K. CHENG** ; **DARIUSH DIVSALAR** ; **STEPHANIE DUY**. Structured low-density parity-check codes with bandwidth efficient modulation. *Wireless Sensing and Processing IV.*, 2009, vol. 7349
- **CHATZIKONTANTINOU CHRISTOS** ; **SPAFARIDIS XENOFON**. A novel soft-demapping algorithm for 16-APSK, for systems employing uncoded modulation. *Proceedings of the Pan-Hellenic Electrical and Computer Engineering Student Conférence*, April 2014, vol. 7
- **LI, JIANPING** ; **YAMENG SHI**. Simplified Soft-output Demapper Based on a Linear Transformation Technique for M-ary PSK. *Sensors & Transducers*, October 2014, vol. 181 (10)

- **A. BARRE** ; **E. BOUTILLON** ; **N. BIAS** ; **D. DIAZ**. A polar-based demapper of 8PSK démodulation for DVB-S2 systems. *SiPS*, 2013
- **MOSTAFA RIZK** ; **AMER BAGHDADI** ; **MICHEL JÉZÉQUEL**. A Literature Survey on Algorithms and Hardware Architectures of Max-Log-MAP Demapping. *Journal of Circuits, Systems and Computers*, 2022, vol. 31 (3)
- **J. W. PARK** ; **M. H. SUNWOO** ; **P. S. KIM** ; **D.-I. CHANG**. Low complexity soft-decision demapper for high order modulation of DVB-S2 System. *Proc. of the IEEE International SoC Design Conference (ISOCC)*, 02 November 2008
- **A. BAGHDADI** ; **M. JEZEQUEL**. ASIP-based universal demapper for multiwireless standards. *IEEE Embedded Systems Letters,*, May 2009 (1), 9-13
- **M. RIZK** ; **A. BAGHDADI** ; **M. JEZEQUEL** ; **Y. MOHANNA** ; **Y. ATAT**. NISC-based soft-input soft-output demapper. *IEEE Transactions on Circuits and Systems*, November 2015, vol. 62
- **I. ALI, U. WASENMÜLLER** ; **N. WEHN**. A high throughput architecture for a low complexity soft-output demapping algorithm. *Advances in Radio Science*, 2015, vol. 13
- **Q. WANG** ; **Q. XIE** ; **Z. WANG** ; **S. CHEN** ; **L. HANZO**. A Universal Low-Complexity Symbol-to-Bit Soft Demapper. *IEEE Transactions on Vehicular Technology*, January 2014, vol. 63 (1)